Europäisches Patentamt

European Patent Office

Office européen des brevets

(11) Publication number: **0 365 249**
**A2**

## EUROPEAN PATENT APPLICATION

(21) Application number: **89310576.7**

(22) Date of filing: **16.10.89**

(51) Int. Cl.⁵: **C23C 14/35 , H01J 37/00**

(30) Priority: **17.10.88 JP 260991/88**

(43) Date of publication of application:
**25.04.90 Bulletin 90/17**

(84) Designated Contracting States:
**DE FR GB**

(71) Applicant: **ANELVA CORPORATION**
**8-1 Yotsuya 5-chome**
**Fuchu-shi Tokyo 183(JP)**

(72) Inventor: **Akao, Yasuhiko**
**c/o Anelva Corporation 8-1 Yotsuya 5-chome**
**Fuchu-shi 183 Tokyo(JP)**
Inventor: **Sakurai, Takehiro**
**c/o Anelva Corporation 8-1 Yotsuya 5-chome**
**Fuchu-shi 183 Tokyo(JP)**

(74) Representative: **Crisp, David Norman et al**
**D. YOUNG & CO. 10 Staple Inn**
**London, WC1V 7RD(GB)**

(54) **Method and apparatus for sputtering.**

(57) A magnetron discharge type sputtering apparatus for sputtering a target with plasma. The apparatus comprises a target (I), a magnetic field application unit (3; 3I, 32) disposed at the back surface of said target and rotating means (5, 6) for rotating a magnetic field (30) produced on the surface of the target by said magnetic field application unit. The magnetic field application unit is arranged such that erosion produced in the target by the sputtering tends to be deeper in an edge portion of an erosion area than a central portion thereof. In addition a method of magnetron discharge sputtering using plasma generated by magnetron discharge for sputtering a target (I), wherein erosion produced in the target by the sputtering is deeper in a peripheral portion of the erosion area of the target than a central portion thereof.

*FIG. 5*

## Method and Apparatus for Sputtering

This invention relates to a sputtering apparatus particularly for forming thin films in vacuum and, more particularly but not exclusively, to a high-speed low-temperature sputtering apparatus. This type of preferred apparatus may be used for forming, on a mass production scale, recording films of magnetic disks or optical magnetic disks, or Sendust or Permalloy films as yokes of magnetic heads or thin film magnetic heads by using a magnetic material as a target.

It has been proposed that magnetron discharge sputtering apparatus, in which a magnetic field normal to an electric field is provided in the neighborhood of a target surface to trap electrons and produce high density plasma, may be capable of producing a film having a desired thickness quickly and by mass production.

Where the magnetic field is fixed for sputtering, the target is locally eroded, and the utility of the apparatus is thus reduced. Accordingly, a system, in which a magnetic field is rotated during sputtering has been proposed in order to provide uniform erosion of the target surface and thus improve the utility of the apparatus and extend the life of the target.

Figs. I and 2 show target erosion obtained using known apparatus.

Fig. I is a schematic plan view showing a disk-like target, of a known magnetron discharge sputtering apparatus, and

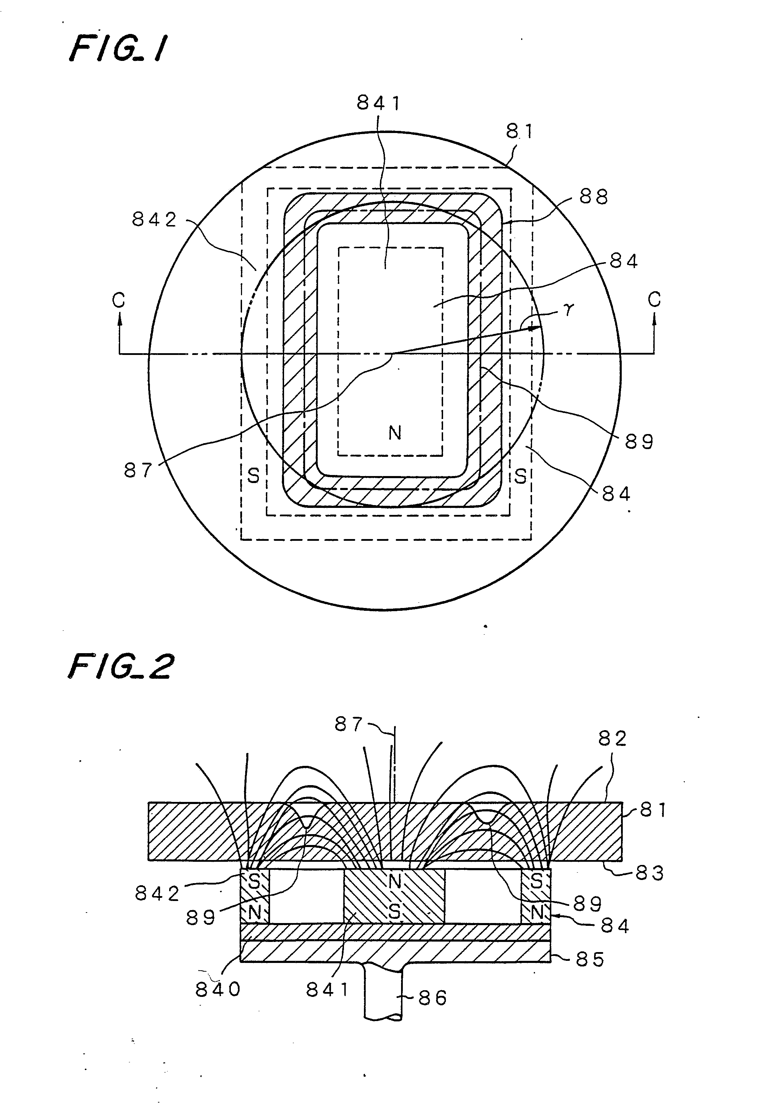

Fig. 2 is a schematic sectional view taken along line C-C in Fig. I.

The Figures illustrate only the portion of known magnetron discharge sputtering apparatus which include the target. In the Figures, the disk-like target 8I has its surface 82 subjected to sputtering in a vacuum. A magnetic field application unit 84 is provided at the back surface 83 of target 8I. The magnetic field application unit 84 is supported on a turntable 85 with a shaft 86 for rotation about a center 87 of rotation. The magnetic field application unit 84 includes permanent magnets, 84I and 842, and a yoke 840. The pole surface of the central magnet 84I and that of the outer magnet 842 are of opposite polarities to each other. The outer magnet 842 has a frame-like construction and surrounds the central magnet 84I as can be seen from the areas 84I and 842 defined by dashed lines in Fig. I.

Fig. I illustrates the shape of the erosion area 88 produced in the target 8I in case where the magnetic field is held stationary during sputtering.

The term erosion area means an entire sputtered area having 5% or more of the maximum erosion depth. The erosion area 88 obtained using the magnetic field produced by the magnet array of Figure I is substantially rectangular, and is shown by shading. The broken line 89 indicates a maximum erosion depth portion of the erosion area 88 resulting from quickest erosion. Usually, this portion is substantially linear. This maximum erosion depth portion is referred to as quickest erosion portion. The position of the quickest erosion portion 89 can be accurately determined by experiments. However, it can be roughly estimated from the distribution of the magnetic field produced by the magnetic field application unit 84.

In the above prior art apparatus, the magnetic field is rotated by operating the turntable 85.

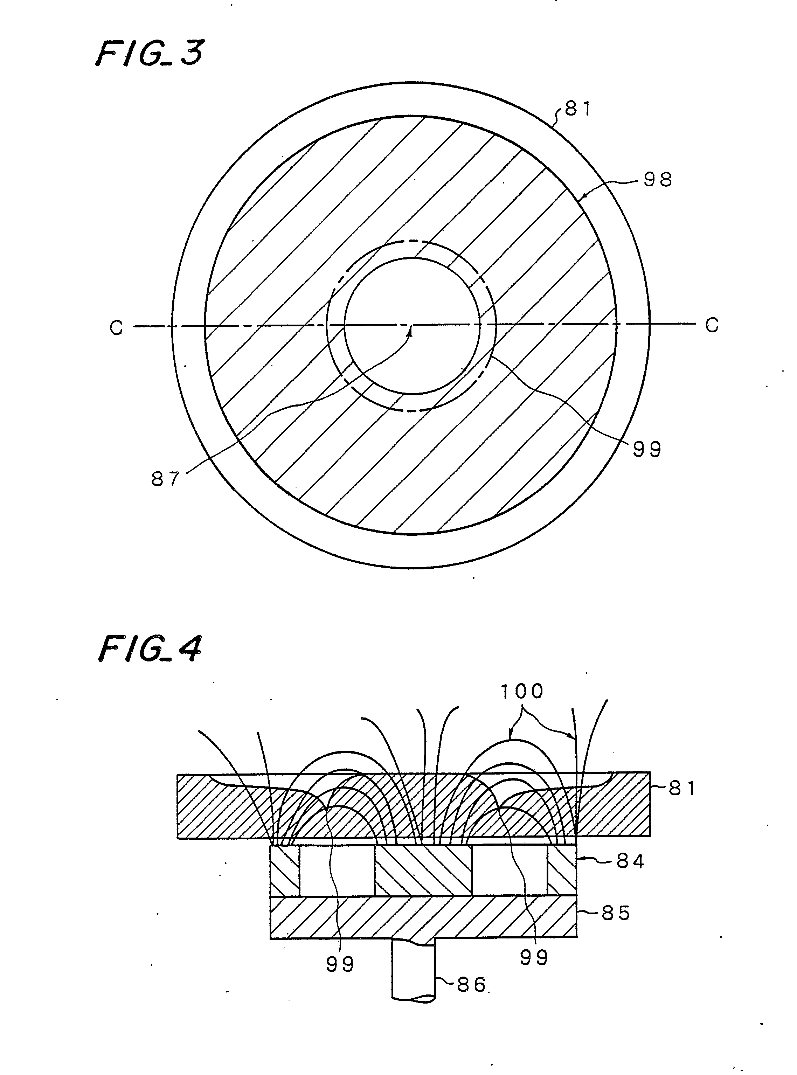

Figs. 3 and 4 show target erosion in the case where the magnetic field is rotated during sputtering of the target 8I.

Fig. 3 is a schematic plan view showing the erosion obtained with a rotating magnetic field provided for sputtering by the magnetron disharge sputtering apparatus according to Fig. I.

Fig. 4 is a sectional view taken along line C-C in Fig. 3.

As shown in the Figures, an erosion area 98, defined by two circles concentric with the center 87 of rotation of the magnetic field (shown in Fig. 3), is formed over the entire area where the field is rotated.

The rate of erosion is not uniform over the surface of target 8I. Particularly, there is a strong tendency for the formation of a circular groove 99 by strong erosion at a position close to the center 87 of rotation of the magnetic field in the broad erosion area 98, between the concentric circles, produced using a rotating magnetic field. If such a groove 99 is formed in an initial stage of sputtering, this groove 99 is subjected to a stronger magnetic field than the remaining sputtering area. Therefore, the groove 99 is subject to accelerated quick erosion compared to the rest of the sputtering area, thus increasing non-uniformity of erosion.

This phenomenon is particularly pronounced where a ferromagnetic target is used. In this case, only the local circular groove area 99 is strongly eroded even if the magnetic field is rotated, i.e. the rotating magnetic field is ineffective, resulting in inferior target utility. Also, in this case deterioration of the performance of film formation on a process substrate (such as film formation rate, film thickness distribution and step cover factor) results.

There have been various proposals for providing uniform target erosion in order to improve the utility of the target and for solving the aforementioned problems. Typically, there is a technique disclosed in Japanese Patent Disclosure Sho 62-60866. The principles underlying the disclosed technique are as follows. Erosion rate under a stationary magnetic field as shown in Fig. I will be considered. Any center 87 of rotation of a magnetic field is taken as a reference point. It is assumed that n plasma groups exist on a circle concentric with point 87 and with radius r. It is also assumed that plasma in the same plasma group provides a uniform erosion rate. The erosion rate provided by plasma is different between different plasma groups. The higher the plasma density, the higher the erosion rate. The erosion rate provided by plasma in an i-th plasma group found on a circle of radius r is denoted by $R_{ri}$ (Å/min.) (i = I, 2, ..., n). It is assumed that plasma groups having the same erosion rate $R_{ri}$ (Å/min.) are found on a circle over a length corresponding to a circumferential angle $\Theta_{ri}$ (rad.) ($\Theta_{ri}$ being the ratio of the circumferential length of plasma providing the same erosion rate $R_{ri}$ on circle having radius r to distance r from the center of rotation). When the magnetic field is rotated, the erosion rate $D_r$ of various parts of the target on the circle of radius r is the average value of the erosion rate $R_{ri}$ and is given by

$$D_r = \sum_{i=1}^{n} R_{ri}\Theta_{ri}/2\pi \, (\overset{o}{A}/min.)$$

Therefore, the following two conditions A and B shall be considered.

Condition A : If the aforementioned erosion rate $R_{ri}$ under a stationary magnetic field takes a constant value $R_{ri}$ on all points on the circle with radius r and is zero in the other areas (condition A), we have

$$D_r = (R_r/2\pi) \sum_{i=1}^{n} \Theta_{ri}$$

This equation can be written as

$$D_r = (R_r/2\pi) \sum_{i=1}^{n} (L_{ri}/r)$$

where $L_{ri}$ is the length of arc subtending each angle $\Theta_{ri}$.

Condition B : Although $R_r$ generally varies with r, if $R_r$ has a constant value R for each radius r, i.e., irrespective of the radius r (condition B), we may have an equation

$$D_r = (R/2\pi) \sum_{i=1}^{n} \Theta_{ri}$$

This equation can be rewritten as

$$D_r = (R/2\pi) \sum_{i=1}^{n} (L_{ri}/r)$$

According to the above technique, both conditions A and B are satisfied substantially over the entire target surface by providing a plurality of magnets having the same shape at the back of the target in such an arrangement that term

$$\sum_{i=1}^{n} \Theta_{ri}$$

and hence

$$\sum_{i=1}^{n} (L_{ri}/r)$$

is constant over the entire target surface, thus ensuring uniformity of erosion. In other words, according to this known technique erosion is caused in the same way and to the same depth over the entire sputtering area of target under a rotating magnetic field. When this is obtained, uniformity of erosion on the target surface can be ensured, and the utility of the target is increased.

In other words, this known apparatus should permit improvement of the utility of a target when it is used for high-speed low-temperature sputtering using a magnetic target to form, on a mass production scale, large area recording films of magnetic disks or optical magnetic disks, Sendust or Permalloy films as yokes of magnetic heads or thin film magnetic heads. In this case, however, the thickness of film deposited on a substrate fluctuates by 5% or above, that is, the thickness distribution of the film is insufficient.

Fig. I0 shows experimental data of the thickness distribution of a film formed on a substrate. In the graph, the abscissa represents the substrate position, and the ordinate represents the film thickness shown in a normalized form with the maximum thickness taken as unity. Dashed plot A represents an example of the thickness distribution of a film obtained with the prior art apparatus described above. It will be seen that the maximum-to-minimum thickness ratio is about I: 0.8.

We have now found it possible to provide a magnetron discharge type sputtering apparatus, which permits a wide and a uniform thickness distribution to be obtained.

We have also found it possible to provide a magnetron discharge sputtering method for obtaining a wide and a uniform thickness distribution.

According to one aspect of the present invention there is provided a magnetron discharge sputtering apparatus for sputtering a target with plasma, comprising a target I; a magnetic field application unit disposed at a back surface of said target; and rotation means 5, 6 for rotating a magnetic field 30 produced at the surface of said target by said magnetic field application unit, said magnetic field application unit being arranged such that erosion produced in said target by said sputtering is deeper in a peripheral portion of an erosion area than a central portion thereof.

In a preferred embodiment the target is substantially flat.

In a preferred embodiment of the invention, said erosion depth is at a maximum at a position which is radially spaced apart from the center of said target by a distance corresponding to 50 to 85% of the radius of said target.

In another preferred embodiment of the invention, said magnetic field application unit comprises magnetic poles arranged such that, when there are n plasma groups on a circle of radius r from the center of rotation of the rotating magnetic field, the plasma in each plasma group provides an equal erosion rate and an i-th plasma group is found on said circle over an arc $L_{ri}$, the value of

$$\sum_{i=1}^{n} (L_{ri}/r)$$

varies with position on said target in a radial direction.

In a further preferred embodiment of the invention, said magnetic field application unit comprises magnetic poles, the arrangement of the magnetic poles and the strength of the magnetic field produced being such that, when the magnetic field is rotated, there are n plasma groups on a circle of radius r from the center of rotation of the rotating magnetic field and the erosion rate $D_r$ (Å/min.) of various parts of the target on the circle of radius r is given as an equation:

$$D_r = \sum_{i=1}^{n} R_{ri}\Theta_{ri}/2\pi \quad (i = 1, 2, ..., n)$$

where $R_{ri}$ (Å/min.) is the erosion rate under a stationary magnetic field provided by plasma in an i-th plasma group found on a circle of radius r, $R_{ri}$ increases according to the increase in magnetic field strength and $\Theta_{ri}$ is the ratio of the circumferential length of the i-th plasma to the distance r from the center of rotation, the erosion rate $D_r$ becomes larger as the radius r becomes larger.

In a further preferred embodiment of the invention, said magnetic field application unit comprises magnetic poles arranged such that, when there are n plasma groups on a circle of radius r from the center of rotation of the rotating magnetic field, plasma in each plasma group provides an equal erosion rate, an i-th plasma group is found on said circle over an arc $L_{ri}$ and the value of an equation

$$\sum_{i=1}^{n} (L_{ri}/r) = \sum_{i=1}^{n} \Theta_{ri}$$

where $\Theta_{ri}$ is an angle subtended by said arc is equal at each position on said target in the radial direction, there is a relationship
$\Theta_{r_1\,i} > \Theta_{r2i}$
for two radii $r_1$ and $r_2$ $(r_1 > r_2)$.

In a still further preferred embodiment of the invention, said magnetic field application unit comprises permanent magnets.

According to another aspect of the invention there is provided a method of magnetron discharge sputtering using plasma generated by magnetron discharge for sputtering a target I, wherein erosion produced in said target by said sputtering is deeper in a peripheral portion of an erosion area of said target than a central portion thereof. The target is preferably substantially flat.

In a preferred embodiment of the invention, the erosion becomes progressively deeper as one goes from the central portion toward the peripheral portion of said target.

In another preferred embodiment of the invention, said target is sputtered such that said erosion has a maximum depth at a position which is radially spaced apart from the center of said target by a distance corresponding to 50 to 85% of the radius of said target.

Various preferred features and embodiments of the invention will now be described by way of nonlimiting example, with reference to the accompanying drawings, in which:

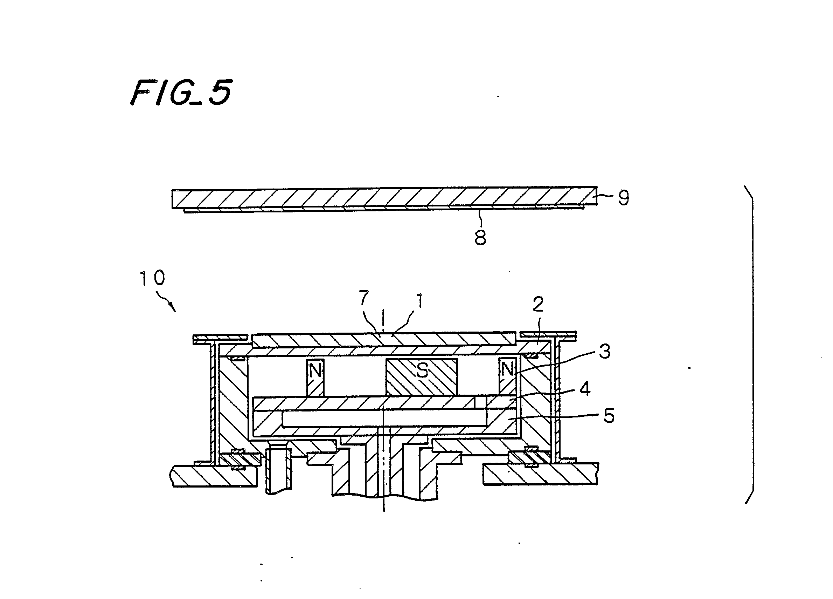

Fig. 5 is a schematic elevational sectional view showing a substrate and a target section facing the substrate of an embodiment of the apparatus according to the present invention;

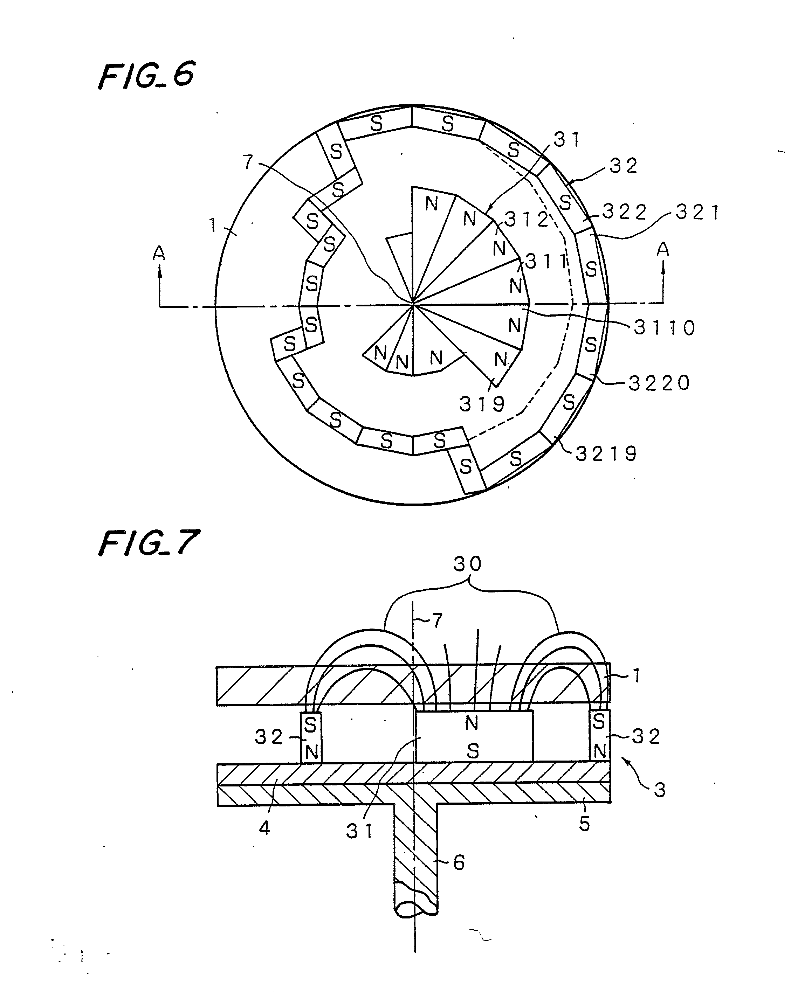

Fig. 6 is a schematic plan view showing the arrangement of magnets on the back surface of a target in an embodiment of the magnetron discharge type sputtering apparatus according to the invention;

Fig. 7 is a schematic sectional view taken along line A-A in Fig. 6;

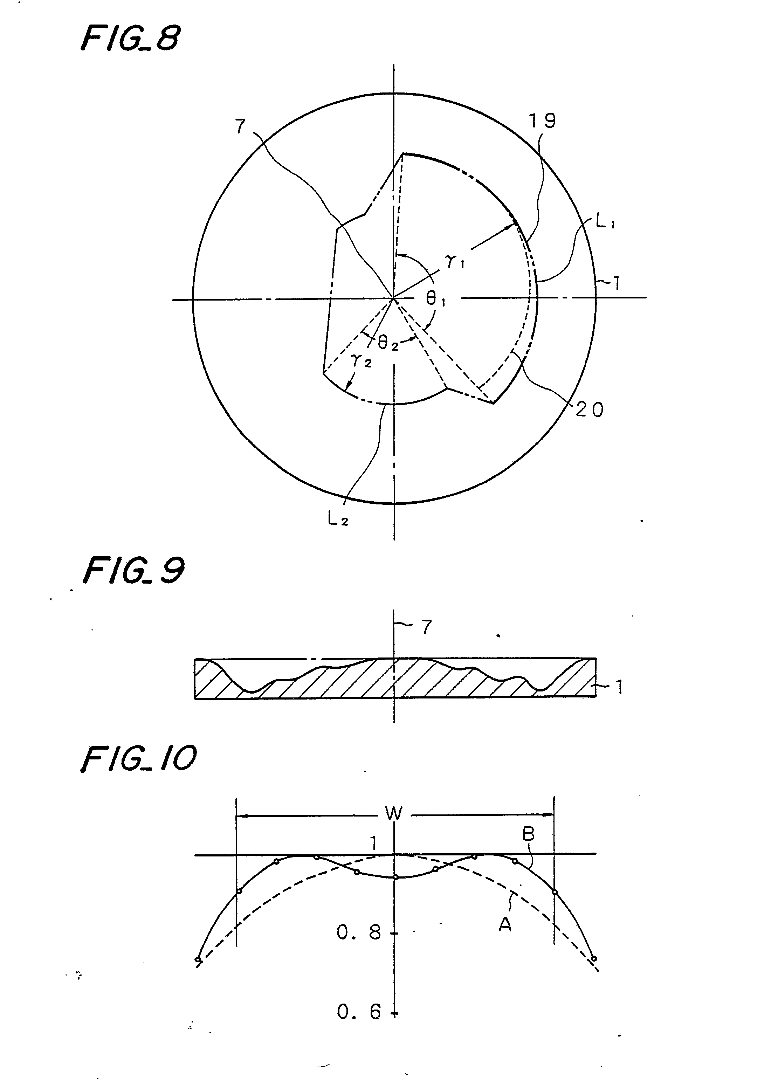

Fig. 8 is a view showing a quickest erosion portion;

Fig. 9 is a sectional view taken along line A-A in Fig. 6 showing an erosion shape formed in the target which is obtained with a rotating magnetic field provided by the embodiment shown in Fig. 6; and

Fig. 10 is a view showing film thickness distribution.

Figs. 5 to 9 illustrate one embodiment of the magnetron discharge sputtering apparatus according to the present invention.

Fig. 5 is an elevational sectional view showing the main part of the magnetron discharge sputtering apparatus, i.e. a work substrate and a target section facing the substrate. In the Figure, generally designated at 10 is the target section, in which a flat target 1 is provided on a target holder 2. Below the target holder 2, a magnetic field application unit 3 i.e. a unit which generates or produces a magnetic field, comprising magnets (e.g. permanent magnets) is disposed on a turntable 5 via a yoke 4. The turntable 5 is rotated via a shaft 6 about a center 7 of rotation to rotate the magnetic field provided by the magnetic field application unit 3. Meanwhile, a substrate 8 is provided on a substrate holder 9. Film formation material produced by sputtering of the target 1 is deposited on the substrate 8 to form a film.

The components of the apparatus described above are provided in a vacuum vessel (not shown). In Fig. 5, the surface of target 1, which in this embodiment comprises a ferromagnetic target, facing the substrate 8 is sputtered in the vacuum vessel. The magnetic field application unit 3 is provided at the back surface of the target 1, i.e. in the vicinity of the target surface which is not sputtered. As shown in Figs. 6 and 7, it has an inner permanent magnet group 31 (comprising permanent magnets 311, 312, ..., 3110) and an outer permanent magnet group 32 (comprising permanent magnets 321, 322, ..., 3220). These permanent magnet groups are disposed on a common yoke 4, such that corresponding pole surfaces have opposite polarities to each other. The entire unit is supported on the turntable 5 and is rotatable using a shaft 6 about an axis 7 of the rotation.

The magnetic field application unit 3 is constructed such that erosion produced in the target 1 by sputtering is shallowest in a central portion of the erosion area of the target and becomes deeper as one goes toward the outer periphery of the erosion area.

Experiments conducted with the magnetic field application unit 3, under a static magnetic field provided by the array of magnetic groups 31 and 32 as shown in Fig. 6 reveal a quickest erosion portion 19 formed on the surface of target 1 as shown in Fig. 8.

Also, experiments conducted with the magnetic field application unit 3 rotated for sputtering with respect to target 1, reveal that erosion having a sectional profile as shown in Fig. 9 is obtained. In this case, the film deposited on the substrate 8 has a thickness distribution as shown by the solid curve B in Fig. 10.

As is obvious from the experimental results shown by the solid plot in Fig. 9, the erosion produced in the target is shallowest at the center of rotation of the magnetic field and becomes progressively deeper with slight irregularities as one goes radially outwardly from the center 7 of rotation, and it is deepest at a position near the edge of the erosion area and then quickly becomes shallower as one goes toward the edge. Preferably from the point of view of the utility of the target, the position of the greatest depth of erosion is suitably radially spaced from the center 7 of the target 1 by a distance corresponding to 50 to 85% of the radius of the target 1.

From the experimental results shown by the solid plot B in Fig. 10, the maximum-to-minimum thickness ratio of the film deposited on the substrate (shown at 8 in Fig. 5) is about 1 : 0.9. This means that the uniformity of the thickness distribution is improved substantially, i.e. doubled, compared to the prior art case (as shown by dashed plot A).

Embodiments of the apparatus and method for magnetron discharge sputtering according to the present invention, which provide the above experimental results as shown in Figs. 9 and 10, will now be described in more detail.

In an embodiment of the invention, unlike the prior art structures, magnets 31 and 32 are arranged such that

$$\sum_{i=1}^{A} \Theta_{ri},$$

and hence

$$\sum_{i=1}^{A} (L_{ri}/r),$$

is different in different radial directions of the target while the conditions A and B noted before are substantially satisfied.

This embodiment will be described in greater detail with reference to Fig. 8 showing the quickest erosion portion 19 produced using a stationary magnetic field.

In the embodiment of Fig. 8, it is assumed that there is a first plasma group (n = 1) with a plasma erosion rate at a distance $r_1$ from the center of rotation and that there is a second plasma group at a distance of $r_2$ from the rotation center. The erosion rates of the first and second plasma groups may be equal or different. The value of

$$\sum_{i=1}^{n} \Theta_{ri},$$

and hence

$$\sum_{i=1}^{n} (L_{ri}/r),$$

on the circle of radius $r_1$, and circles in the vicinity with respect to the first plasma group, is $\Theta_1$ and hence $L_1/r_1$ (i being one, i.e., n = 1). Also, the value of

$$\sum_{i=1}^{n} \Theta_{ri},$$

and hence

$$\sum_{i=1}^{n} (L_{ri}/r),$$

on the circle of radius $r_2$, and circles in the vicinity with respect to the second plasma group is $\Theta_2$ and hence $L_2/r_2$ (here i being also one). In this embodiment, the poles of the magnetic field application unit are arranged such that $\Theta_1 > \Theta_2$ for the two radii $r_1$ and $r_2$ ($r_1 > r_2$). This arrangement is different from the prior art technique noted above.

With this magnetron discharge sputtering apparatus, when a turntable 5 is turned to rotate the magnetic field during sputtering with respect to a target I, a wide and waste-free erosion area can be ensured, while obtaining quicker, and hence deeper, erosion in peripheral portions of the target I than is obtained in the central portion therof, as shown in Fig. 9.

Since such an erosion profile can be obtained, it is possible to deposit a film having uniform thickness over a wider area of the substrate 8 while maintaining the high utility of the target.

The invention is also applicable to an apparatus, in which the conditions A and B are not satisfied.

For example, as in the prior art technique noted above, the angles $\Theta_1$ and $\Theta_2$ in the quickest erosion section I9 in Fig. 8 are set to be $\Theta_1 = \Theta_2$, while four magnets 32I, 322, 3220 and 32I9 and respectively corresponding magnets 3II, 3I2, 3I9 and 3II0 are made stronger than the other magnets, i.e. an erosion rate under a stationary magnetic field increases according to the increase of a magnetic field strength. In this case, R varies around the circle of radius $r_1$ depending on the angle and also varies depending on the radius r (i.e. with $r_1$ and 2). Thus, a relationship $D_{r1} > D_{r2}$ holds, and an apparatus having the construction according to the present invention can be obtained.

If it is desired to obtain an erosion profile free from the depressed portions shown by the dashed plot in Fig. 9, the arrangement of outer magnets 32 shown in Fig. 6 is changed as shown by the dashed line, thus providing a magnetic field application unit 3 having a pole arrangement such as to provide a quickest erosion portion as shown by the dashed line 20 in Fig. 8. By so doing, the required erosion profile can be obtained.

In the above embodiment the target is held stationary while the magnetic field application unit is rotated. However, it is also possible to rotate the former while holding the latter stationary. Furthermore, it is also possible to use electromagnets instead of permanent magnets for the magnetic field application unit.

According to the present invention, it is possible to provide an excellent magnetron discharge sputtering apparatus, which permits quick formation of a uniform film on a substrate while providing a target with high utility value.

## Claims

I. A magnetron discharge sputtering apparatus for sputtering a target with plasma, comprising a target (I); a magnetic field application unit disposed at a back surface of said target; and rotation means (5, 6) for rotating a magnetic field (30) produced at the surface of said target by said magnetic field application unit, said magnetic field application unit being arranged such that erosion produced in said target by said sputtering is deeper in a peripheral portion of an erosion area than a central portion thereof.

2. Apparatus according to claim I, wherein said erosion depth is at a maximum at a position radially spaced from the center of said target by a distance corresponding to 50 to 85% of the radius of said target.

3. Apparatus according to claim I or 2, wherein said magnetic field application unit comprises magnetic poles arranged such that, when there are n plasma groups on a circle of radius r from the center of rotation of the rotating magnetic field, plasma in each plasma group provides an equal erosion rate and an i-th plasma group is found on said circle over an arc $L_{ri}$, the value of

$$\sum_{i=1}^{n} (L_{ri}/r)$$

varies with the position on said target in the radial direction.

4. Apparatus according to any preceding claim, wherein said magnetic field application unit comprises magnetic poles, the arrangement of the magnetic poles and the strength of the magnetic field being such that, when the magnetic field produced by the magnetic field application unit is rotated, there are n plasma groups on a circle of a radius r from the center of rotation of the rotating magnetic field and an erosion rate $D_r$ (Å/min.) of various parts of the target on the circle of radius r is given by

$$D_r = \sum_{i=1}^{n} R_{ri}\Theta_{ri}/2\pi \quad (i = 1, 2, ..., n)$$

where $R_{ri}$ (Å/min.) is an erosion rate under a stationary magnetic field provided by plasma in an i-th plasma group found on a circle of radius r, $R_{ri}$ increases according to the increase of the magnetic field strength and $\Theta_{ri}$ is the ratio of the circumferential length of the i-th plasma to the distance r from the center of rotation, the erosion rate $D_r$ becomes larger as the radius r becomes larger.

5. Apparatus according to any preceding claim, wherein said magnetic field application unit has magnetic poles arranged such that, when there are n plasma groups on a circle of radius r from the center of rotation of the rotating magnetic field, plasma in each plasma group provides an equal erosion rate, an i-th plasma group is found on said circle over an arc $L_{ri}$ and the value of an equation

$$\sum_{i=1}^{n} (L_{ri}/r) = \sum_{i=1}^{n} \Theta_{ri}$$

where $\Theta_{ri}$ is an angle subtended by said arc is equal at each position on said target in the radial direction, there is a relationship
$\Theta_{r_1 i} > \Theta_{r2i}$
for two radii $r_1$ and $r_2$ ($r_1 > r_2$).

6. Apparatus according to any preceding claim, wherein said magnetic field application unit comprises permanent magnets.

7. A method of magnetron discharge sputtering using plasma generated by magnetron discharge for sputtering a target (I), wherein erosion produced in said target by said sputtering is deeper in a peripheral portion of an erosion area of said target than a central portion thereof.

8. A method according to claim 7, wherein said erosion becomes progressively deeper as one goes from the central portion toward the peripheral portion of the erosion area of said target.

9. A method according to claim 7 or 8, wherein said target is sputtered such that said erosion has a maximum depth at a position radially spaced apart from the center of said target by a distance corresponding to 50 to 85% of the radius of said target.

I0. A method of magnetron discharge sputtering using an apparatus according to any one of claims I to 6.

II. An object which has been produced using an apparatus according to any one of claims I to 6.

## FIG_1

## FIG_2

FIG_3

FIG_4

*FIG_5*

## FIG. 6

## FIG. 7

*FIG_8*

*FIG_9*

*FIG_10*